# DEMANDE DE BREVET EUROPEEN

(11) **EP 3 176 830 A1**
(43) Date de publication de la demande: **07.06.2017**
(21) Numéro de dépôt: 16200035.0
(22) Date de dépôt: 22.11.2016
(51) Int. Cl.: H01L 31/0236, H01L 31/032

(54) **PROCÉDÉ DE FABRICATION D'UN AGENCEMENT POUR EMPILEMENT DE CELLULE PHOTOVOLTAÏQUE EN COUCHES MINCES**

(30) Priorité: 02.12.2015 FR 1561717
(71) Demandeur: COMMISSARIAT À L'ÉNERGIE ATOMIQUE ET AUX ÉNERGIES ALTERNATIVES, 75015 Paris (FR)
(72) Inventeur: EMIEUX, Fabrice, 38340 Voreppe (FR); DELLEA, Olivier, 42350 La Talaudiere (FR); DUCROS, Cédric, 38690 Bevenais (FR); GRENET, Louis, 38000 Grenoble (FR)
(74) Mandataire: Brunelli, Gérald

(57) **Abrégé**

Procédé de fabrication d'un agencement pour empilement de cellule photovoltaïque en couches minces comprenant les étapes de :
- dépôt (S1) d'un film de microsphères ordonnées sur un substrat initial en défilement;
- gravure (S2) des microsphères et/ou recuit (S3) d'ancrage des microsphères;
- dépôt (S5) d'une couche de molybdène (2) sur les microsphères intégrées (1 A) au substrat (1);
- dépôt (S6) d'une couche ultra-mince d'absorbeur de lumière (3) sur la couche de molybdène (2); et
- dépôt (S7) d'une couche tampon (4) et d'une couche fenêtre (5) sur la couche ultra-mince d'absorbeur de lumière (3).

## Description

L'invention porte sur un procédé de fabrication d'un agencement pour empilement de cellule photovoltaïque en couches minces,.

Une cellule photovoltaïque est un composant électronique qui, exposé à la lumière, génère de l'électricité. Elle peut être utilisée seule (calculatrice, montre...) mais, la plupart du temps, les cellules sont regroupées dans des modules ou panneaux photovoltaïques.

Il existe plusieurs familles de cellules photovoltaïques, dont les plus répandues sont les cellules en silicium cristallin et les cellules en couches minces.

Les technologies dites couches minces sont basées sur l'utilisation de couches extrêmement fines de l'épaisseur de quelque microns et consistent à déposer sous vide sur un substrat (verre, métal, plastique, ...) une fine couche uniforme composée d'un ou plus généralement de plusieurs matériaux.

Les cellules en couches minces sont fabriquées en déposant une ou plusieurs couches semi-conductrices et photosensibles sur un support ou substrat de verre, de plastique, ou d'acier... Cette technologie permet de diminuer le coût de fabrication. La technologie des cellules en couches minces connaît actuellement un fort développement.

Les cellules photovoltaïques dont la couche absorbeur est à base d'alliage de cuivre Cu, d'indium In, de gallium Ga, et de sélénium Se, connues sous la dénomination "CIGS", sont actuellement les cellules solaires en couches minces présentant les meilleurs rendements de conversion photovoltaïque (21,7%), comme divulgué dans le document "Properties of Cu(In,Ga)Se2 solar cells with new record efficiencies up to 21,7%", de Jackson P., Hariskos D., Wuerz R., Kiowski O., Bauer A., Friedlmeier T.M., et Powalla M., (2014); physica status solidi (RRL)-Rapid Research Letters, 9999. La formule générale du CIGS peut donc s'écrire Culn₁₋ₓGaₓS_{2(1-y)}Se_{2y} avec 0 ≤x ≤1 et 0 ≤y ≤1. Généralement, x≈0.3 et y=1.

La structure générale d'une telle cellule photovoltaïque comprend du Molybdène Mo, du CIGS, du sulfure de cadmium CdS, et de l'oxyde transparent conducteur TCO. La rareté de l'indium In peut être un frein au développement de cette technologie à grande échelle.

Pour faire face à ce problème il est envisagé de réduire l'épaisseur de la couche active en CIGS, comme divulgué dans le document " Influence of the Cu (In, Ga) Se2 thickness and Ga grading on solar cell performance." De Lundberg O., Bodegård M., Malmström J., et Stolt L. (2003); Progress in Photovoltaics: Research and Applications, 11 (2), 77-88.

Lorsque la couche active de CIGS est réduite en épaisseur, le courant de court-circuit Jsc et la puissance que peut fournir la cellule solaire se trouvent notablement réduits du fait de l'absorption incomplète du spectre lumineux incident. Des travaux, tels que décrits dans le document "Light Coupling and Trapping in Ultra-thin Cu (In, Ga) Se2 Solar Cells using Dielectric Scattering Patterns" de C. van Lare, G. Yin, A. Polman, et M. Schmid, (2015) ACS nano, ont montré que réaliser une cellule solaire sur un substrat texturé permet de compenser en partie la faible épaisseur de l'absorbeur CIGS par augmentation du chemin optique dans l'absorbeur grâce au piégeage optique c'est-à-dire augmentation de la part diffuse du faisceau lumineux traversant la cellule solaire.

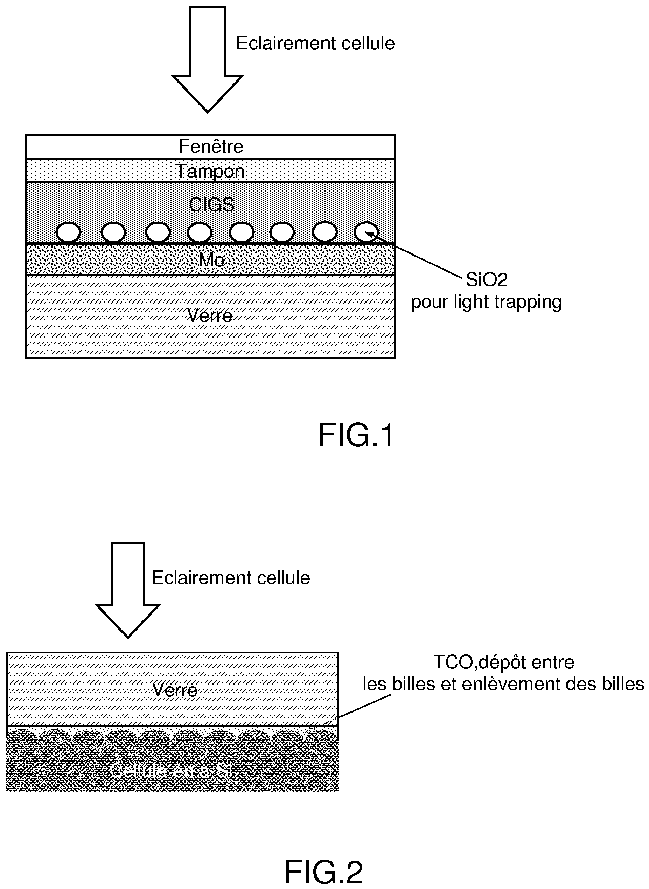

La figure 1 illustre un tel mode de réalisation.

Toutefois dans cette référence le piégeage optique ne provient pas du substrat mais de l'inclusion de particules de silice entre l'électrode arrière et le CIGS. A cause de cette étape supplémentaire, il n'est pas possible d'enchaîner les étapes de dépôt de l'électrode arrière et de CIGS. Cela conduit à une interface arrière moins bien contrôlée et à l'apparition de recombinaisons à cet endroit.

Comme décrit dans le document WO 2013/160570, l'utilisation de microsphères pour améliorer le piégeage optique dans les cellules solaires en couches minces est déjà connue. Cependant dans un tel mode de réalisation, tel qu'illustré sur la figure 2, les microsphères servent de masque de dépôt et sont ensuite supprimées de la structure. Le contact électrique arrière de la cellule ainsi obtenu présente des discontinuités qui nuisent à ses propriétés de conduction électrique et de réflexion optique.

Bien sûr, cela s'applique également à une couche active à base d'alliage de cuivre Cu, de zinc Zn, de l'étain Sn, ainsi que de sélénium Se et/ou de soufre S, connue sous la dénomination "CZTS", dont la formule générale peut donc s'écrire Cu₂ZnSnS_{4(1-y)}Se_{4y} avec 0 ≤ y ≤ 1.

Un but de l'invention est de pallier les problèmes précédemment cités, et notamment de fournir un procédé de fabrication d'un agencement pour empilement de cellule solaire en couches minces.

Le substrat pour agencement pour empilement de cellule photovoltaïque en couches minces intègre une couche supérieure à base de microsphères intégrées présentant un motif régulier, ou, en d'autres termes présentant un ou plusieurs axes de symétrie.

La couche de microsphères intégrées ayant un motif régulier, voire même périodique, permet d'avoir le bénéfice de la diffraction de la lumière en plus de sa diffusion, ainsi, une cellule photovoltaïque en couches minces utilisant un tel substrat aura un meilleur rendement.

Le substrat de base utilisé est généralement en verre ou vitrocéramique (le plus souvent en verre sodocalcique), et les microsphères généralement en silice pure (les microsphères peuvent également être dopées ou contenir du sodium ou potassium afin de constituer un apport de ce ou ces éléments à l'absorbeur).

Par exemple, le motif régulier de la couche supérieure à base de microsphères intégrées comprend un réseau périodique hexagonal compact bidimensionnel. La taille du motif est ajustable car déterminée par le diamètre des microsphères.

Un agencement pour empilement de cellule photovoltaïque en couches minces peut comprendre une couche de substrat pour cellule photovoltaïque tel que précédemment décrit, une couche de molybdène disposée sur les microsphères intégrées au substrat, une couche ultra-mince d'absorbeur de lumière disposée sur la couche de molybdène, ainsi qu'une couche tampon disposée sur la couche ultra-mince d'absorbeur de lumière, et une couche fenêtre disposée sur la couche tampon.

Un tel agencement utilisant un substrat intégrant une couche supérieure à base de microsphères intégrées présentant un motif régulier, permet d'avoir le bénéfice de la diffraction de la lumière en plus de sa diffusion, ainsi, une cellule photovoltaïque utilisant un tel empilement a un rendement amélioré.

On entend par couche ultra-mince d'absorbeur de lumière une couche d'épaisseur comprise entre 200 nm et 1 µm.

La couche ultra-mince d'absorbeur de lumière peut être en CIGS, i.e. en alliage de cuivre, d'indium, de gallium et de sélénium.

En variante, la couche ultra-mince d'absorbeur de lumière peut être en CZTS, i.e. en alliage de cuivre, de zinc, d'étain, ainsi que de sélénium et/ou de soufre.

L'agencement peut comprendre une couche de diélectrique disposée entre la couche de substrat intégrant une couche supérieure à base de microsphères intégrées présentant un motif régulier et la couche molybdène.

Une telle couche de diélectrique peut jouer le rôle de barrière de diffusion pour les impuretés du substrat et/ou des microsphères, ou le rôle d'améliorer/optimiser la topographie obtenue après l'ancrage des microsphères.

Selon un aspect de l'invention, il est proposé un procédé de fabrication d'un agencement pour empilement de cellule photovoltaïque en couches minces comprenant les étapes de :
- dépôt d'un film de microsphères ordonnées sur un substrat initial en défilement;
- gravure des microsphères et/ou recuit d'ancrage des microsphères;
- dépôt d'une couche de molybdène sur les microsphères intégrées au substrat;
- dépôt d'une couche ultra-mince d'absorbeur de lumière sur la couche de molybdène; et
- dépôt d'une couche tampon et d'une couche fenêtre sur la couche ultra-mince d'absorbeur de lumière.

Un tel procédé permet d'obtenir au final des cellules photovoltaïques de rendement amélioré, intégrant un substrat intégrant une couche supérieure à base de microsphères intégrées présentant un motif régulier, ce qui permet d'avoir le bénéfice de la diffraction de la lumière en plus de la diffusion.

Dans un mode de mise en oeuvre, le procédé comprend, en outre, une étape de dépôt d'une couche de diélectrique sur les microsphères intégrées au substrat avant le dépôt de molybdène; la couche de diélectrique se trouvant alors entre les microsphères intégrées au substrat et la couche de molybdène.

Selon un mode de mise en oeuvre, le dépôt de la couche de molybdène sur les microsphères intégrées au substrat est fait sur une épaisseur comprise entre 100 et 2000 nm, de préférence sur une épaisseur de sensiblement 500 nm.

Ainsi on obtient une bonne conductivité électrique proportionnellement à la quantité de matériau mise en oeuvre.

Dans un mode de mise en oeuvre, le dépôt du film de microsphères met en oeuvre des microsphères de diamètre compris entre 100 nm et 5 µm, et avantageusement de diamètre de sensiblement 1 µm.

Ainsi la taille du motif est adaptée à la gamme de longueurs d'onde d'absorption du CIGS.

L'invention sera mieux comprise à l'étude de quelques modes de réalisation décrits à titre d'exemples nullement limitatifs et illustrés par les dessins annexés sur lesquels :
- les figures 1 et 2 illustrent schématiquement des agencements pour empilement de cellule photovoltaïque en couches minces, selon différents états de la technique,
- la figure 3 illustre schématiquement un substrat pour agencement pour empilement de cellule photovoltaïque en couches minces selon un aspect de l'invention;
- les figure 4a et 4b illustrent schématiquement des agencements pour empilement de cellule photovoltaïque en couches minces selon un aspect de l'invention;
- les figures 5 à 12 illustrent schématiquement le procédé selon divers aspects de l'invention; et
- la figure 13 représente un tableau de résultat de la présente invention.

Sur les différentes figures, les éléments ayant des références identiques sont identiques.

En outre, dans la description, même si les exemples décrits mettent généralement en oeuvre du CIGS comme absorbeur de lumière, l'invention s'applique également avec du CZTS comme absorbeur de lumière.

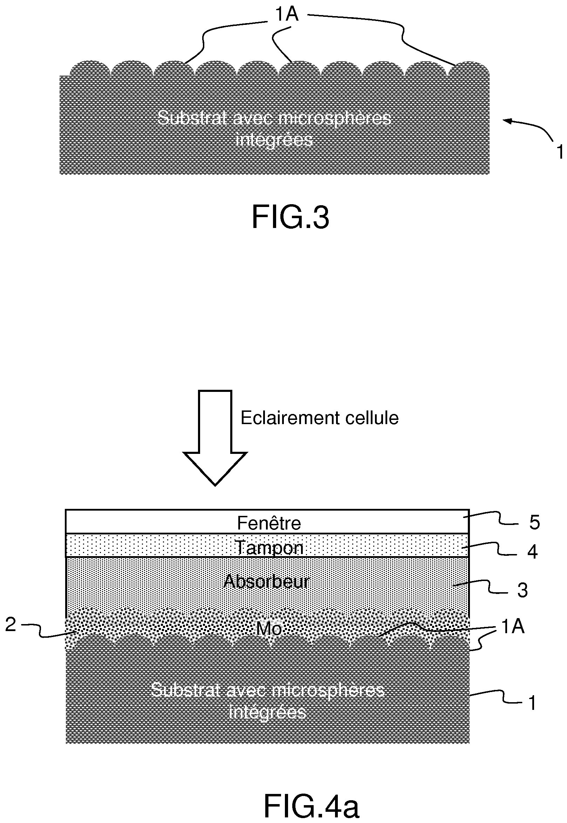

La figure 3 représente un substrat 1 pour agencement pour empilement de cellule photovoltaïque en couches minces intégrant une couche supérieure 1 A à base de microsphères intégrées présentant un motif régulier.

Le motif régulier voire en outre périodique est idéalement une structure hexagonale compacte bidimensionnelle. La taille du motif est ajustable car déterminée par le diamètre des microsphères.

Un agencement pour empilement de cellule photovoltaïque en couches minces selon un aspect de l'invention est illustré sur la figure 4a. L'agencement comprend une couche de substrat intégrant une couche supérieure à base de microsphères intégrées présentant un motif régulier selon la figure 3, une couche 2 de molybdène Mo disposée sur les microsphères 1A intégrées au substrat 1, une couche ultra-mince d'absorbeur de lumière, par exemple en CIGS ou CZTS, disposée sur la couche de molybdène 2, ainsi qu'une couche tampon 4 disposée sur la couche ultra-mince 3 d'absorbeur de lumière, et une couche fenêtre 5 disposée sur la couche tampon 4.

L'utilisation d'un tel substrat augmente donc l'efficacité de la cellule photovoltaïque car il permet d'avoir le bénéfice de la diffraction de la lumière en plus de la diffusion.

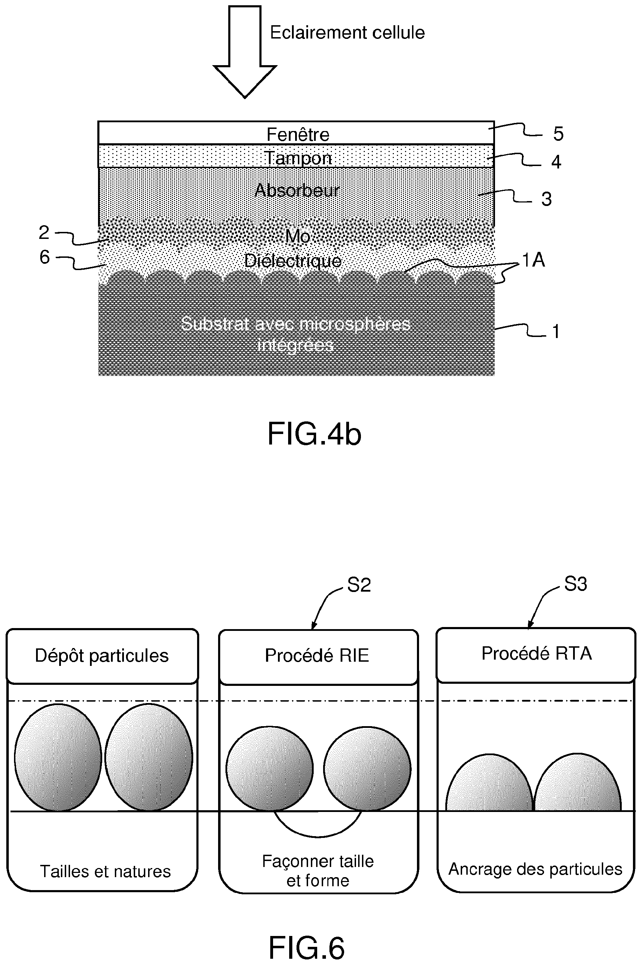

En variante, comme illustré sur la figure 4b, l'agencement pour empilement de cellule photovoltaïque en couches minces de la figure 4a peut également comprendre une couche de diélectrique 6 disposée entre la couche de substrat 1 intégrant une couche supérieure à base de microsphères intégrées 1A présentant un motif régulier et la couche molybdène 2.

Une telle couche de diélectrique 6 peut jouer le rôle de barrière de diffusion pour les impuretés du substrat et/ou des microsphères, ou le rôle d'améliorer/optimiser la topographie obtenue après l'ancrage des microsphères.

La présente invention propose également un procédé de texturation de substrat, adaptée à la réalisation de cellules solaires à base d'absorbeur de lumière, tel du CIGS ou CZTS, comprenant une épaisseur d'absorbeur réduite.

Ce procédé permet d'obtenir une topographie de surface régulière, voire également périodique, apte à améliorer le piégeage optique qui permet de compenser les pertes d'absorption dues à la réduction d'épaisseur de l'absorbeur.

La texturation est obtenue grâce au dépôt d'une monocouche de microsphères. Ces microsphères sont ensuite liées au substrat lors d'une gravure et/ou d'un recuit thermique, qui a aussi pour effet de les enterrer partiellement. Les microsphères sont donc conservées et forment la base de la texturation, contrairement aux autres méthodes utilisant des microsphères pour la texturation qui utilisent un dépôt interstitiel puis un retrait des microsphères et qui ont pour inconvénient de générer un contact électrique arrière de la cellule discontinu ce qui nuit à ses propriétés de conduction électrique et de réflexion optique.

Une étape de gravure sèche (par gravure ionique réactive ou RIE pour acronyme de "Reactive-Ionic Etching" en langue anglaise) peut être utilisée avant ou après le recuit pour modifier la taille et la forme des microsphères c'est-à-dire le rapport de forme, sans modifier le pas du réseau. L'ensemble ainsi obtenu est apte à l'usage comme substrat dans un procédé de réalisation de cellules photovoltaïques en couches minces, notamment dans un outil en ligne car la texturation est ici réalisée indépendamment du contact arrière en molybdène.

Selon la nature du substrat en verre ou vitrocéramique et des microsphères, il est possible de moduler l'apport de sodium ou potassium à l'absorbeur CIGS ou CZTS. En particulier, si le verre ou vitrocéramique et les microsphères contiennent peu ou pas de sodium ou potassium, on met en oeuvre une couche barrière de diffusion surmontée d'une couche d'apport de sodium, typiquement du molybdène dopé au sodium. Une seconde solution consiste à gérer l'apport de sodium ou potassium par l'utilisation de microsphères contenant du sodium ou potassium, cette solution permet de s'affranchir d'une couche barrière et d'un apport ultérieur de sodium ou potassium.

La suite de la description détaille divers modes de mise en oeuvre du procédé de l'invention.

Le procédé de fabrication, selon l'invention, d'un agencement pour empilement de cellule photovoltaïque en couches minces comprend :
- une première étape S1 de dépôt d'un film ou tapis de microsphères ordonnées sur un substrat initial en défilement;
- une deuxième étape S2 de gravure des microsphères et/ou une troisième étape S3 de recuit d'ancrage des microsphères;
- une quatrième étape optionnelle S4 de dépôt d'une couche de diélectrique sur les microsphères intégrées au substrat avant le dépôt de molybdène; la couche de diélectrique se trouvant alors entre les microsphères intégrées au substrat et la couche de molybdène;
- une cinquième étape S5 de dépôt d'une couche de molybdène sur les microsphères intégrées au substrat;
- une sixième étape S6 de dépôt d'une couche ultra-mince d'absorbeur de lumière sur la couche de molybdène; et
- une septième étape S7 de dépôt d'une couche tampon et d'une couche fenêtre sur la couche ultra-mince d'absorbeur de lumière.

La première étape S1 de dépôt d'un film de microsphères ordonnées sur un substrat initial en défilement, est similaire à celle décrite dans le document WO 2012/113745.

Ce dépôt de microsphère, de diamètre compris entre 100 nm et 5 µm, et préférentiellement de 1 µm se fait grâce à la technique Langmuir-Blodgett avec un équipement Boostream©. Le film ou tapis de microsphères peut être réalisé avec un ou deux diamètres de microsphères distincts (mélange de tailles compris dans l'échelle donnée, proportion de 0% à 100% de chaque taille) pour réaliser une double texturation si on considère deux diamètres distincts.

Cet équipement permet de déposer sur des substrats flexibles ou rigides de façon ordonnée et en monocouche des particules dont la dimension peut varier entre quelques nanomètres et plusieurs centaines de micromètres.

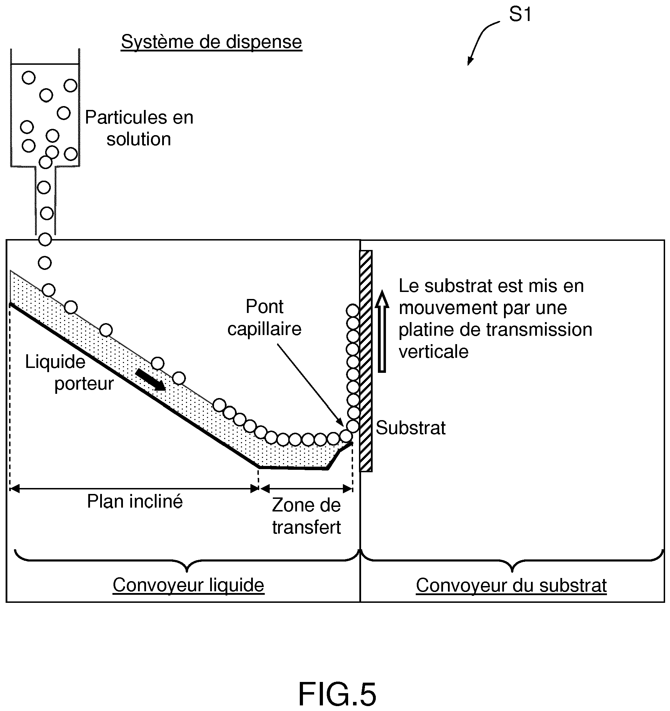

Le principe de fonctionnement de l'équipement est présenté sur la figure 5, sur laquelle on peut distinguer trois parties. Une première partie permet de dispenser des particules en solution. Une deuxième partie comprend un convoyeur utilisant un liquide pour transporter, ordonner et transférer les particules sur un substrat rigide ou flexible. Ce convoyeur liquide comprend un plan incliné et une zone horizontale appelée zone de transfert. La liaison entre le liquide porteur et le substrat est assurée par un pont capillaire. Une troisième partie comprend un convoyeur mettant en mouvement le substrat sur lequel doivent être déposées les particules.

Pour que le procédé fonctionne, les particules doivent impérativement avoir la propriété de flotter à la surface du liquide porteur soit par leurs propriétés intrinsèques de surface ou par fonctionnalisation de surface. La nature de ces particules peut être des oxydes, du métal, des polymères ou une association de ces matériaux (ex : polymère/métal).

Cette première étape consiste donc à dispenser les particules à la surface du liquide porteur. Le liquide porteur véhicule les particules jusqu'à la zone de transfert. Les particules s'accumulent dans la zone de transfert puis remontent le plan incliné. Les particules présentes sur le plan incliné exercent alors une pression qui force dans une certaine mesure l'ordonnancement des particules présentes dans la zone de transfert.

Les paramètres opératoires sont les suivants : la dimension des colloïdes est avantageusement de 1 µm (comprise entre 100nm et 500µm), le solvant est du butanol ou chloroforme, la concentration de la solution colloïdale est de 35g/l (comprise entre 1 et 100 g/l), le liquide porteur est de l'eau déionisée à 30°C (comprise entre 20 et 50°C), le débit du liquide porteur est de 500 ml/min (compris entre 100 et 2000 ml/min), le débit d'injection des particules est de 0,5 ml/min (compris entre 0,1 et 5 ml/min), et la vitesse de tirage est de 3 cm/min (comprise entre 0,1 et 20 cm/min).

La deuxième étape S2 de gravure des microsphères permet de façonner la taille et la forme des microsphères. La technique utilisée peut être une gravure sèche (ou RIE pour acronyme de "Reactive Ionic Etching" en langue anglaise) mettant en oeuvre une décharge RF (13.56MHz) de 2.5W/cm² (entre 1 et 10W/cm²) sous vide 50mT (entre 10 et 200mT) et sous gaz SF6/O2 ou CHF3/O2.

La troisième étape S3 de recuit d'ancrage des microsphères consiste en un recuit thermique rapide (ou RTA pour acronyme de "Rapid Thermal Anneal") pour assurer la cohésion entre les microsphères et le substrat, permet également de lisser la topographie par un effet d'enterrement des microsphères. Ce recuit doit excéder la température de transition vitreuse du verre en cas de substrat en verre (typiquement entre 500°C et 600°C). Ce recuit se fait à 800°C (entre 600°C et 1200°C) pendant un temps de trois minutes (typiquement entre 10 s et 10 min) avec des rampes de montée et descente en température comprise entre 0.1°C/s et 10°C/s avec un ralentissement de la rampe en température au passage de la transition vitreuse.

La figure 6 représente les deuxième étape S2 et troisième étape S3.

La quatrième étape optionnelle S4 de dépôt d'une couche de diélectrique sur les microsphères intégrées au substrat avant le dépôt de molybdène (la couche de diélectrique se trouvant alors entre les microsphères intégrées au substrat et la couche de molybdène).

Ce dépôt d'un matériau diélectrique après le dépôt de billes. Ce dépôt peut jouer deux rôles distincts et les propriétés du dépôt dépendent de la fonction jouée par cette couche.

Un premier rôle est un rôle de barrière de diffusion pour les impuretés du substrat et/ou des microsphères. Cette barrière peut être constituée d'oxydes de silicium SiOx, de nitrures de silicium SiNx, ou d'alumine Al₂O₃, d'épaisseur de 10 nm (comprise entre 2 et 500 nm) déposée par dépôt chimique en phase vapeur assisté par plasma, pulvérisation cathodique, évaporation, ou sol-gel.

Un second rôle est un rôle de couche additionnelle de lissage topographique après la troisième étape S3 de recuit des microsphères. Le rôle de cette couche est d'améliorer/optimiser la topographie obtenue après l'ancrage des microsphères (recuit). Cette couche peut être constituée d'oxydes de silicium SiOx, de nitrures de silicium SiNx, ou d'alumine Al₂O₃, d'épaisseur de 100 nm (comprise entre 10 et 500 nm) déposée par dépôt chimique en phase vapeur assisté par plasma, pulvérisation cathodique, évaporation, ou sol-gel.

La cinquième étape S5 de dépôt de molybdène sur les microsphères intégrées au substrat a une épaisseur de 500 nm (comprise entre 100 et 2000 nm) qui constitue à la fois le contact électrique arrière et le réflecteur optique de la cellule; cette couche est classiquement réalisée par pulvérisation cathodique magnétron (PVD-PCM) dont les paramètres opératoires sont une pression de 3 mTorr (entre 1 et 10 mT) une atmosphère neutre (Argon 30 sccm - entre 2 et 200 sccm) et une décharge DC ou DC pulsée typiquement 2W/cm² (entre 0.5 et 10W/cm²), cette couche peut aussi être élaborée par évaporation par faisceau d'électrons (EBPVD) sous vide.

La sixième étape S6 de dépôt d'une couche ultra-mince d'absorbeur de lumière sur la couche de molybdène, par exemple du CIGS ultra-mince (500 nm, compris entre 200 nm et 1 µm) par une méthode issue de la littérature. Des méthodes de réalisation du CIGS sont bien connues de l'homme de l'art, et sont par exemple décrites dans "Handbook of photovoltaic science and engineering" (p 559-564) de A. Luque et S. Hegedus, 2011. Deux grands types de méthodes de dépôt existent, le but final étant d'obtenir une couche de CIGS avec des rapports élémentaires suivant (0.75≤Cu/(In+Ga)≤0.95; 0.55<In/(In+Ga)≤0.85 et 0.15≤Ga/(In+Ga)≤0.45) :
- la coévaporation : consiste à évaporer simultanément les éléments Cu, In, Ga, Se en chauffant le substrat à 550°C (450°C<T<650°C) pour obtenir le matériau désiré. Les taux d'évaporation des éléments peuvent être constants au cours du procédé (co-évaporation en une étape) ou être variables pour obtenir des gradients de composition (co-évaporation en trois étapes).
- la sélénisation de précurseurs : consiste à déposer des couches de précurseurs contenant au moins du Cu, In et Ga dans les proportions (0.75≤Cu/(In+Ga)≤0.95; 0.55≤In/(In+Ga)≤0.85 et 0.15≤Ga/(In+Ga)≤0.45) par une méthode de dépôt sous vide (pulvérisation cathodique, évaporation, ...) ou hors vide (sol-gel, electrodépôt, ...) à température comprise entre la température ambiante et 600°C puis à recuire cette couche de précurseurs sous une atmosphère contenant du Se (Se élémentaire, H2Se) et éventuellement du S à une température de 550°C (450°C<T<650°C), à pression proche de la pression atmosphérique (0.1 mBar<P<2bars). Le recuit est typiquement un recuit du type recuit rapide.

La septième étape S7 de dépôt d'une couche tampon et d'une couche fenêtre sur la couche ultra-mince d'absorbeur de lumière, tel le CIGS, consiste en la fabrication de la jonction. Des méthodes de fabrication d'une jonction photovoltaïque comprenant un absorbeur à base de CIGS sont connues de l'homme de l'art et par exemple décrites dans "Handbook of photovoltaic science and engineering" (p 564-571) de A. Luque et S. Hegedus, 2011. Cette fabrication de jonction peut notamment comporter :
- un dépôt d'une couche tampon de 50 nm (10 nm < e < 200 nm) à base de CdS, ZnS, In2S3 ou autre par bain chimique ou par dépôt sous vide (pulvérisation cathodique, dépôt de couche atomique ou ALD pour acronyme de "atomic layer deposition" en langue anglaise, ...)
- un dépôt d'une couche fenêtre de 200 nm (50 nm < e < 500 nm) par pulvérisation cathodique. Il s'agit généralement d'une bi-couche (ZnO/ZnO:Al, ZnO/ITO, ...). D'autres méthodes de dépôts (dépôt par bain chimique ou CBD pour acronyme de "chemical bath deposition" en langue anglaise, ALD) ou d'autres matériaux sont possibles (nanofils métalliques, SnO2:F, ...).

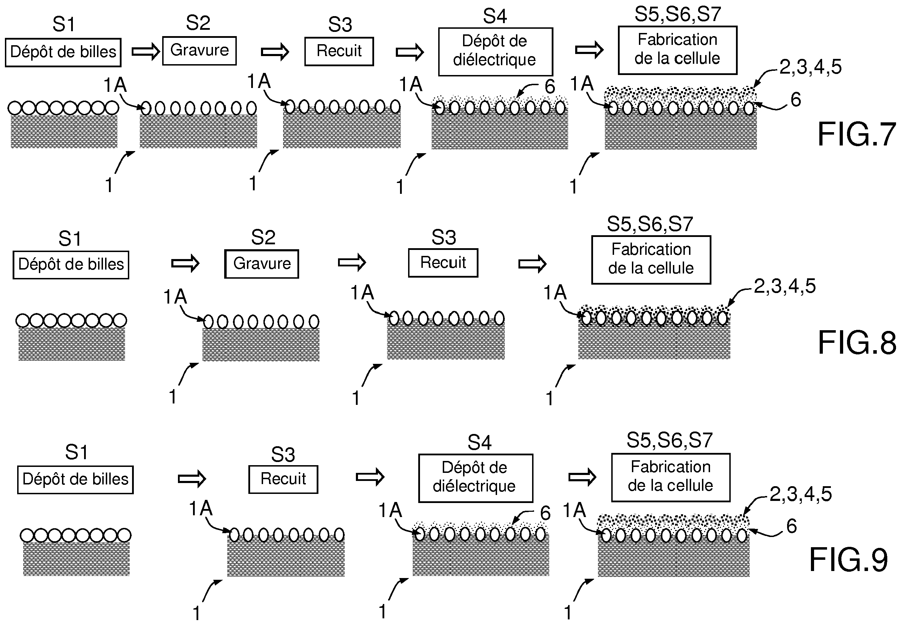

Les figures 7 à 12 illustrent différents modes de réalisation du procédé selon divers aspects de l'invention.

La figure 7 représente une variante du procédé comprenant les étapes de dépôt S1 d'un film de microsphères ordonnées sur un substrat initial en défilement, de gravure S2 des microsphères, de recuit S3 d'ancrage des microsphères, de dépôt S4 d'une couche de diélectrique sur les microsphères intégrées au substrat, de dépôt S5 d'une couche de molybdène sur les microsphères intégrées au substrat, de dépôt S6 d'une couche ultra-mince d'absorbeur de lumière sur la couche de molybdène, de dépôt S7 d'une couche tampon et d'une couche fenêtre sur la couche ultra-mince d'absorbeur de lumière.

La figure 8 représente une variante du procédé comprenant les étapes de dépôt S1 d'un film de microsphères ordonnées sur un substrat initial en défilement, de gravure S2 des microsphères, de recuit S3 d'ancrage des microsphères, de dépôt S5 d'une couche de molybdène sur les microsphères intégrées au substrat, de dépôt S6 d'une couche ultra-mince d'absorbeur de lumière sur la couche de molybdène, de dépôt S7 d'une couche tampon et d'une couche fenêtre sur la couche ultra-mince d'absorbeur de lumière.

La figure 9 représente une variante du procédé comprenant les étapes de dépôt S1 d'un film de microsphères ordonnées sur un substrat initial en défilement, de recuit S3 d'ancrage des microsphères, de dépôt S4 d'une couche de diélectrique sur les microsphères intégrées au substrat, de dépôt S5 d'une couche de molybdène sur les microsphères intégrées au substrat, de dépôt S6 d'une couche ultra-mince d'absorbeur de lumière sur la couche de molybdène, de dépôt S7 d'une couche tampon et d'une couche fenêtre sur la couche ultra-mince d'absorbeur de lumière.

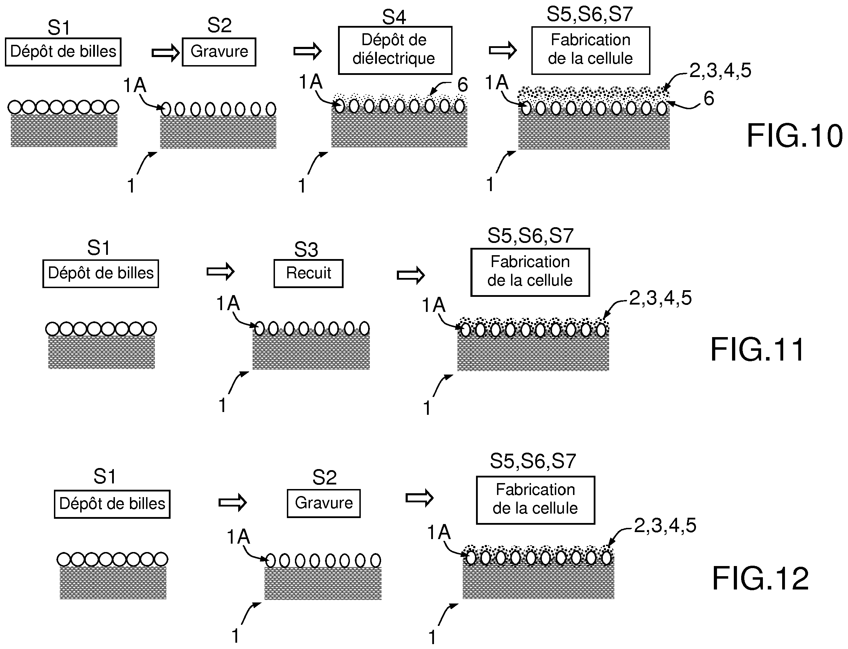

La figure 10 représente une variante du procédé comprenant les étapes de dépôt S1 d'un film de microsphères ordonnées sur un substrat initial en défilement, de gravure S2 des microsphères, de dépôt S4 d'une couche de diélectrique sur les microsphères intégrées au substrat, de dépôt S5 d'une couche de molybdène sur les microsphères intégrées au substrat, de dépôt S6 d'une couche ultra-mince d'absorbeur de lumière sur la couche de molybdène, de dépôt S7 d'une couche tampon et d'une couche fenêtre sur la couche ultra-mince d'absorbeur de lumière.

La figure 11 représente une variante du procédé comprenant les étapes de dépôt S1 d'un film de microsphères ordonnées sur un substrat initial en défilement, de recuit S3 d'ancrage des microsphères, de dépôt S5 d'une couche de molybdène sur les microsphères intégrées au substrat, de dépôt S6 d'une couche ultra-mince d'absorbeur de lumière sur la couche de molybdène, de dépôt S7 d'une couche tampon et d'une couche fenêtre sur la couche ultra-mince d'absorbeur de lumière.

La figure 12 représente une variante du procédé comprenant les étapes de dépôt S1 d'un film de microsphères ordonnées sur un substrat initial en défilement, de gravure S2 des microsphères, de dépôt S5 d'une couche de molybdène sur les microsphères intégrées au substrat, de dépôt S6 d'une couche ultra-mince d'absorbeur de lumière sur la couche de molybdène, de dépôt S7 d'une couche tampon et d'une couche fenêtre sur la couche ultra-mince d'absorbeur de lumière.

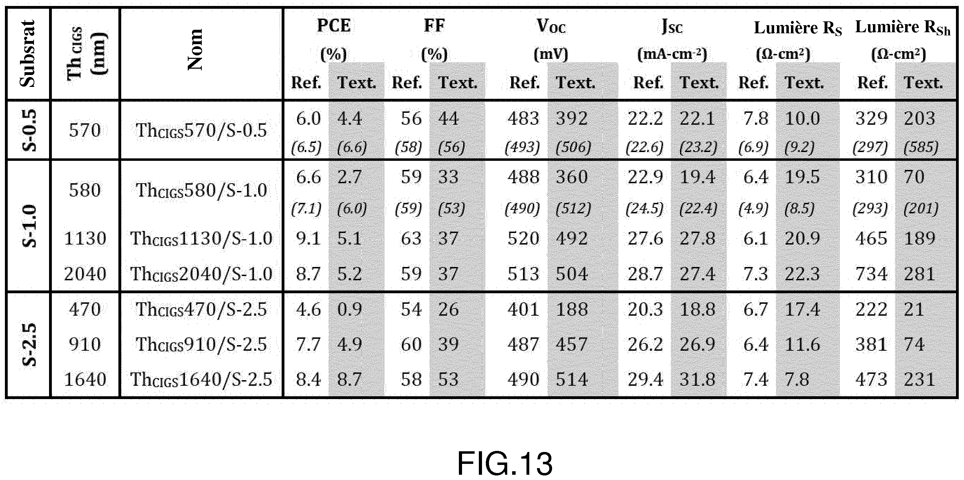

La figure 13 représente les résultats de l'invention.

## Revendications

1. Procédé de fabrication d'un agencement pour empilement de cellule photovoltaïque en couches minces comprenant les étapes de :
- dépôt (S1) d'un film de microsphères ordonnées sur un substrat initial en défilement;
- gravure (S2) des microsphères et/ou recuit (S3) d'ancrage des microsphères;
- dépôt (S5) d'une couche de molybdène (2) sur les microsphères intégrées (1 A) au substrat (1);
- dépôt (S6) d'une couche ultra-mince d'absorbeur de lumière (3) sur la couche de molybdène (2); et
- dépôt (S7) d'une couche tampon (4) et d'une couche fenêtre (5) sur la couche ultra-mince d'absorbeur de lumière (3).

2. Procédé selon la revendication 1, comprenant, en outre, une étape de dépôt (S4) d'une couche de diélectrique (6) sur les microsphères intégrées (1A) au substrat (1) avant le dépôt (S5) de molybdène (2); la couche de diélectrique (6) se trouvant alors entre les microsphères intégrées (1 A) au substrat (1) et la couche de molybdène (2).

3. Procédé selon la revendication 1 ou 2, dans lequel le dépôt (S5) de la couche de molybdène (2) sur les microsphères (1A) intégrées au substrat (1) est fait sur une épaisseur comprise entre 100 et 2000 nm.

4. Procédé selon la revendication 3, dans lequel le dépôt (S5) de la couche de molybdène (2) sur les microsphères (1A) intégrées au substrat (1) est fait sur une épaisseur de sensiblement 500 nm.

5. Procédé selon l'une des revendications 1 à 4, dans lequel le dépôt (S1) de microsphères utilise des microsphères dopées au sodium ou au potassium.

6. Procédé selon l'une des revendications 1 à 5, dans lequel le dépôt (S1) du film de microsphères met en oeuvre des microsphères de diamètre compris entre 100 nm et 5 µm.

7. Procédé selon la revendication 5, dans lequel le dépôt (S1) du film de microsphères met en oeuvre des microsphères de diamètre de sensiblement 1 µm.
